# EUROPEAN PATENT SPECIFICATION

(11) **EP 4 410 859 B1**
(45) Date of publication and mention of the grant of the patent: **29.04.2026**
(21) Application number: 22876239.9
(22) Date of filing: 27.09.2022
(51) Int. Cl.: C08G 59/66, C08G 75/12

(54) **THERMOSETTING COMPOSITION AND CURED PRODUCT THEREOF, PHOTO-MELTABLE COMPOSITION, AND STRUCTURAL BODY PRODUCTION METHOD**
WÄRMEHÄRTENDE ZUSAMMENSETZUNG UND GEHÄRTETES PRODUKT DARAUS, LICHTSCHMELZBARE ZUSAMMENSETZUNG UND STRUKTURKÖRPERHERSTELLUNGSVERFAHREN
COMPOSITION THERMODURCISSABLE ET PRODUIT DURCI DE CELLE-CI, COMPOSITION PHOTODURCISSABLE, ET PROCÉDÉ DE PRODUCTION DE CORPS STRUCTURAL

(30) Priority: 01.10.2021 JP 2021162632
(43) Date of publication of application: 07.08.2024
(73) Proprietor: Resonac Corporation, Tokyo 105-7325 (JP)
(72) Inventor: WATANABE Masahito, Tokyo 105-7325 (JP); MIYAMOTO Yuki, Tokyo 105-7325 (JP)
(74) Representative: Berggren Oy
(86) International application number: PCT/JP2022/035972
(87) International publication number: WO 2023/054373

(56) References cited:
- WO-A1-2006/037442
- WO-A1-2016/002534
- WO-A1-2019/107486
- WO-A1-2024/080255
- WO-A1-2024/080256
- WO-A1-2024/204615
- JP-A- 2007 031 526
- JP-A- 2019 515 067
- JP-A- 2021 505 735
- JP-B2- 7 563 099
- KR-B1- 101 235 933

## Description

### Technical Field

The present disclosure relates to a thermosetting composition, a cured product thereof, a photo-meltable composition, and a method for producing a structural body.

### Background Art

A photo-meltable composition which can be melted by light irradiation is used for various use applications. For example, Patent Literature 1 discloses an image forming apparatus including a recording member having a photo-meltable resin layer composed of a photo-meltable composition.

### Citation List

### Patent Literature

Patent Literature 1: JP H11-190883 A

### Summary of Invention

### Technical Problem

In a conventional photo-meltable composition, an organic solvent is required to remove a resin component generated by melting by light irradiation. However, from the viewpoint of the environment, and further, from the viewpoint of safety, damage to substrates, and the like, it is required for the photo-meltable composition that a resin component generated by melting by light irradiation can be removed with an aqueous solvent. Since the photo-meltable composition has such properties, the photo-meltable composition can be expected to be used in a wider range of use applications.

Therefore, a main object of the present disclosure is to provide a thermosetting composition capable of forming a cured product (photo-meltable composition) which can be melted by light irradiation and in which a resin component generated by melting by light irradiation can be removed with an aqueous solvent.

### Solution to Problem

The subject matter of the present invention is characterized in the claims. The present disclosure relates to a thermosetting composition. This thermosetting composition contains a polythiol compound having a disulfide bond, a cyclic ether compound having a polyether chain and two or more cyclic ether groups, a curing accelerator, and a photoradical generator. According to such a thermosetting composition, it is possible to form a cured product (photo-meltable composition) which can be melted by light irradiation and in which a resin component generated by melting by light irradiation can be removed with an aqueous solvent.

Although the reasons for the exertion of such effects are not necessarily certain, the present inventors consider as follows. First, by heating the thermosetting composition, the polythiol compound and the cyclic ether compound react with each other, so that a cured product of the thermosetting composition having a disulfide bond can be obtained. Next, by irradiating the obtained cured product with light, the photoradical generator cleaves the disulfide bond (-S-S-) in the portion irradiated with light, so that the molecular weight can be decreased. As the molecular weight is decreased as described above, the elastic modulus of this portion decreases, so that the cured product may be melted to become a liquid (liquid form). Note that, the resin component generated by melting by light irradiation is presumed to have many polyether chains or hydroxyl groups (derived from cyclic ether groups) and tends to be hydrophilic, so that the resin component can be removed with an aqueous solvent.

Since the thermosetting composition can further shorten a curing time and further improve photo-meltability and water solubility, the thermosetting composition may contain, as the cyclic ether compound, a compound having two cyclic ether groups and a compound having three or more cyclic ether groups.

The cyclic ether group may be an oxirane group from the viewpoint of reactivity and ease of availability.

The present disclosure relates to a cured product of the thermosetting composition. This cured product of the thermosetting composition may be a photo-meltable composition. According to such a cured product of the thermosetting composition, the cured product can be melted by light irradiation and a resin component generated by melting by light irradiation can be removed with an aqueous solvent.

The disclosure also relates to a photo-meltable composition. This photo-meltable composition contains a reaction product of a polythiol compound having a disulfide bond and a cyclic ether compound having a polyether chain and two or more cyclic ether groups, and a photoradical generator. According to such a photo-meltable composition, the photo-meltable composition can be melted by light irradiation and a resin component generated by melting by light irradiation can be removed with an aqueous solvent.

In addition, the present disclosure relates to a method for producing a structural body. This method for producing the structural body includes irradiating at least a part of a first structural body composed of the above-described cured product of the thermosetting composition or the above-described photo-meltable composition with light, and developing the first structural body irradiated with light with an aqueous solvent to obtain a second structural body.

The present disclosure provides a thermosetting composition described in [1] to [3], a cured product of the thermosetting composition described in [4], a photo-meltable composition described in [5], and a method for producing a structural body described in [6].
[1] A thermosetting composition containing: a polythiol compound having a disulfide bond; a cyclic ether compound having a polyether chain and two or more cyclic ether groups; a curing accelerator; and a photoradical generator.
[2] The thermosetting composition described in [1], containing a compound having two cyclic ether groups and a compound having three or more cyclic ether groups as the cyclic ether compound.
[3] The thermosetting composition described in [1] or [2], in which the cyclic ether group is an oxirane group.
[4] A cured product of the thermosetting composition described in any one of [1] to [3].
[5] A photo-meltable composition containing: a reaction product of a polythiol compound having a disulfide bond and a cyclic ether compound having a polyether chain and two or more cyclic ether groups; and a photoradical generator.
[6] A method for producing a structural body, the method including: irradiating at least a part of a first structural body composed of the cured product of the thermosetting composition described in [4] with light, and developing the above-described first structural body irradiated with light with an aqueous solvent to obtain a second structural body.

### Advantageous Effects of Invention

According to the present disclosure, there is provided a thermosetting composition capable of forming a cured product (photo-meltable composition) which can be melted by light irradiation and in which a resin component generated by melting by light irradiation can be removed with an aqueous solvent. Furthermore, according to the present disclosure, there are provided a cured product of the thermosetting composition and a photo-meltable composition which can be melted by light irradiation and in which a resin component generated by melting by light irradiation can be removed with an aqueous solvent. Further, according to the present disclosure, there is provided a method for producing a structural body using the photo-meltable composition.

### Description of Embodiments

Hereinafter, embodiments of the present disclosure will be described in detail.

In the present specification, the term "step" includes not only an independent step but also a step by which an intended action of the step is achieved, even though the step cannot be clearly distinguished from other steps. Furthermore, a numerical value range that has been indicated by use of "to" indicates the range that includes the numerical values which are described before and after "to", as the minimum value and the maximum value, respectively.

Furthermore, in the present specification, when a plurality of substances corresponding to each component exist in the composition, the content of each component in the composition means the total amount of the plurality of substances that exist in the composition, unless otherwise specified. Furthermore, unless otherwise specified, exemplified materials may be used singly or in combination of two or more kinds thereof.

Furthermore, in the numerical value ranges that are described stepwise in the present specification, the upper limit value or the lower limit value of the numerical value range of a certain stage may be replaced with the upper limit value or the lower limit value of the numerical value range of another stage. Furthermore, in the numerical value ranges that are described in the present specification, the upper limit value or the lower limit value of the numerical value range may be replaced with the value shown in Examples. "A or B" may include either one of A and B, and may also include both of A and B.

A thermosetting composition of one embodiment contains a polythiol compound having a disulfide bond (hereinafter, sometimes referred to as "component (A)"), a cyclic ether compound having a polyether chain and two or more cyclic ether groups (hereinafter, sometimes referred to as "component (B)"), a curing accelerator (hereinafter, sometimes referred to as "component (C)"), and a photoradical generator (hereinafter, sometimes referred to as "component (D)").

### Component (A): Polythiol compound having disulfide bond

The component (A) is a compound having a disulfide bond (-S-S-) and two or more thiol groups (-SH). The component (A) may be, for example, a dithiol compound which is a compound having two thiol groups (-SH). The component (A) may be a high-molecular weight component of a polymer or an oligomer. The compound having two thiol groups (-SH) can be regarded as a compound including two thiol groups and a disulfide bond and composed of a group (first linking group) connecting these two thiol groups.

The molecular weight or number average molecular weight of the component (A) may be, for example, 100 to 10000000, 200 to 3000000, 300 to 1000000, 400 to 10000, or 500 to 5000. Note that, the number average molecular weight is a polystyrene conversion value obtained by a gel permeation chromatography (GPC) method using a calibration curve obtained by standard polystyrene.

The component (A) has one or a plurality of (two or more) disulfide bonds in the molecule. The number of disulfide bonds in the component (A) may be, for example, 1 to 1000 or 4 to 50.

The component (A) may be a compound (for example, a polymer or an oligomer) having a linear or branched molecular chain and a terminal group and a disulfide bond in this molecular chain. In this case, the terminal group in the component (A) may be a thiol group. When the component (A) is such a compound, there is a tendency that a cured product having excellent photo-meltability is more easily formed. The molecular chain in the component (A) may include a disulfide bond and a polyether chain, and may be composed of a disulfide bond and a polyether chain.

The component (A) may be, for example, a compound (compound (1)) represented by Formula (1): HS-(X-S-S)ₙ₁-X-SH. In the formula, "X" represents a polyether chain. A plurality of X's may be the same as or different from each other. "n1" represents an integer of 1 or more. "n1" may be, for example, 1 or more or 4 or more, and may be 1000 or less. When the component (A) is the compound represented by Formula (1), the group represented by -(X-S-S)ₙ₁-X- is a first linking group. The compound in which the chain of the compound (1) is extended may be, for example, a Michael adduct of the compound (1) or a thiourethanated product of the compound (1).

The polyether chain as "X" may be, for example, a polyoxyalkylene chain. The polyether chain as "X" may be, for example, a group represented by -X¹-O-X²-O-X³-. X¹ to X³ each independently may be an alkylene group, and may be an alkylene group having 1 to 2 carbon atoms (for example, a methylene group or an ethylene group). Examples of the polyether chain as "X" include - CH₂CH₂-O-CH₂-O-CH₂CH₂-.

Examples of commercially available products of the component (A) include THIOKOL LP series (dithiol having a disulfide bond, manufactured by Toray Fine Chemicals Co., Ltd.). The component (A) can also be obtained by converting a reactive functional group of a compound having a reactive functional group (for example, a carboxy group or a hydroxy group) and a disulfide bond at the terminal into a thiol group. Examples of the compound having a reactive functional group and a disulfide bond at the terminal include 3,3'-dithiodipropionic acid (manufactured by Tokyo Chemical Industry Co., Ltd.), dithiodiethanol, and cystamine.

The content of the component (A) may be 15% by mass or more, 25% by mass or more, or 35% by mass or more, and may be 80% by mass or less, 70% by mass or less, or 60% by mass or less, based on the total amount of the thermosetting composition.

### Component (B): Cyclic ether compound having polyether chain and two or more cyclic ether groups

The component (B) is a compound having a polyether chain and two or more cyclic ether groups. When the thermosetting composition contains the component (B), the resin component generated by melting by light irradiation has many polyether chains or hydroxyl groups (derived from cyclic ether groups) and tends to be hydrophilic, so that this resin component can be removed with an aqueous solvent. The component (B) may be a high-molecular weight component of a polymer or an oligomer.

The cyclic ether group of the component (B) may be a group obtained by removing one hydrogen atom from a cyclic ether compound. Specific examples of the cyclic ether group of the component (B) include an oxirane group (oxiranyl group, epoxy group), an oxetane group (oxetanyl group), a tetrahydrofuryl group, and a tetrahydropyranyl group. Among these, the cyclic ether group may be an oxirane group from the viewpoint of reactivity and ease of availability. That is, the component (B) may be an oxirane compound (epoxy compound) having a polyether chain and two or more oxirane groups (oxiranyl groups, epoxy groups). Note that, in the present specification, the cyclic ether group includes a cyclic ether structure (structure including a cyclic ether group). For example, the oxirane group includes a group including an oxirane structure (structure including an oxirane group (oxiranyl group, epoxy group)) such as a glycidyl group, a glycidyl ether group, or an epoxycyclohexyl group.

The molecular weight or number average molecular weight of the component (B) may be, for example, 100 to 1000000, 100 to 500000, 100 to 10000, 150 to 5000, or 200 to 2000. Note that, the number average molecular weight is a polystyrene conversion value obtained by a gel permeation chromatography (GPC) method using a calibration curve obtained by standard polystyrene.

In a case where the cyclic ether group of the component (B) is an oxirane group (oxiranyl group, epoxy group), the epoxy equivalent of the component (B) may be 50 to 2000 g/eq, 80 to 1500 g/eq, or 100 to 1000 g/eq.

The component (B) may be a compound (hereinafter, sometimes referred to as the component (B1)) having two cyclic ether groups, and may be a compound (hereinafter, sometimes referred to as the component (B2)) having three or more cyclic ether groups. The component (B1) can be regarded as a compound including two cyclic ether groups and a polyether chain and composed of a group (second linking group) connecting these two cyclic ether groups. The component (B2) may be a compound having one or more cyclic ether groups as a side chain or substituent of the second linking group in the component (B1). Since the component (B) can further shorten a curing time and further improve photo-meltability and water solubility, the component (B) may include the component (B1) and the component (B2).

The component (B1) may be a compound (for example, a polymer or an oligomer) having a linear molecular chain and a terminal group and may be a polyether chain in this molecular chain. In this case, the terminal group in the component (B1) may be a cyclic ether group. In a case where the component (B) is the component (B1), there is a tendency that the resin component generated by melting by light irradiation is easily removed with an aqueous solvent. The polyether chain as the molecular chain may have a substituent such as a hydroxyl group or an alkyl group which may have a hydroxyl group. The molecular chain in the component (B1) may include a polyether chain and may be composed of a polyether chain.

The component (B1) may be, for example, a compound (compound (2)) represented by Formula (2): Z-(Y)ₙ₂-Z. In the formula, "Y" represents a polyether chain, and "Z" represents a cyclic ether group. A plurality of Z's may be the same as or different from each other. "n2" represents an integer of 1 or more. "n2" may be, for example, 1 or more or 2 or more, and may be 1000 or less. When the component (B1) is the compound represented by Formula (2), the group represented by -(Y)ₙ₂-is a second linking group.

The polyether chain as "Y" may be, for example, a polyoxyalkylene chain. The polyether chain as "Y" may be, for example, a group represented by -Y¹-O-Y²-O-Y³-. Y¹ to Y³ each independently may be an alkylene group, and may be an alkylene group having 1 to 3 carbon atoms (for example, a methylene group, an ethylene group, or a propylene group). Examples of the polyether chain as "Y" include -CH₂CH₂-O-CH₂-CH₂-O-CH₂CH₂-.

Examples of commercially available products of the component (B1) include DENACOL EX series (EX-850, EX-851, EX-821, EX-830, EX-832, EX-841, EX-861, and EX-920, manufactured by Nagase ChemteX Corporation).

The component (B2) may be a compound having one or more cyclic ether groups as a side chain of the second linking group (polyether chain as "Y") in the component (B1).

Examples of commercially available products of the component (B2) include DENACOL EX series (EX-614B, EX-313, EX-512, and EX-521, manufactured by Nagase ChemteX Corporation).

The content of the component (B) (total of the component (B1) and the component (B2)) may be 15% by mass or more, 25% by mass or more, or 35% by mass or more, and may be 80% by mass or less, 70% by mass or less, or 60% by mass or less, based on the total amount of the thermosetting composition.

A mass ratio of the content of the component (B2) with respect to the content of the component (B) (total of the component (B1) and the component (B2)) (the content (mass) of the component (B2)/the content (mass) of the component (B) (total of the component (B1) and the component (B2))) may be 0.01 to 0.40. When this mass ratio is 0.01 or more, there is a tendency that the curing time of the thermosetting composition can be further shortened, and when this mass ratio is 0.40 or less, there is a tendency that photo-meltability and water solubility can be further improved. This mass ratio may be 0.02 or more or 0.03 or more, and may be 0.35 or less, 0.30 or less, 0.25 or less, 0.20 or less, 0.15 or less, 0.10 or less, or 0.05 or less.

An equivalent ratio of the cyclic ether group of the component (B) with respect to the thiol group of the component (A) (the cyclic ether group of the component (B)/the thiol group of the component (A)) may be, for example, 0.5 to 2.5. When this equivalent ratio is 0.5 or more, there is a tendency that the water solubility of the thermosetting composition can be further improved, and when this equivalent ratio is 2.5 or less, there is a tendency that the photo-meltability can be further improved. This equivalent ratio may be 0.8 or more, 1.0 or more, 1.2 or more, or 1.5 or more, and may be 2.2 or less or 2.0 or less.

### Component (C): Curing accelerator

The component (C) is a component for promoting a (curing) reaction of the component (A) and the component (B), and includes a component (catalyst type curing agent) functioning as a catalyst for the curing reaction. Examples of the component (C) include an amine compound, an imidazole derivative, a quaternary ammonium salt, an organometallic salt, and a phosphorus compound.

Examples of the amine compound include dicyandiamide, trimethylamine, triethylamine, tripropylamine, tributylamine, tri-n-octylamine, dimethylethylamine, dimethylpropylamine, dimethylbutylamine, dimethyl-n-octylamine, 1,4-diazabicyclo[2.2.2]octane, 1,8-diazabicyclo[5.4.0]undeca-7-ene, benzyldimethylamine, 4-methyl-N,N-dimethylbenzylamine, 2,4,6-tris(dimethylaminomethyl)phenol, and 4-dimethylaminopyridine.

Examples of the imidazole derivative include 1-(1-cyanomethyl)-2-ethyl-4-methyl-1H-imidazole, 2-ethyl-4-methylimidazole, 2-methylimidazole, 2-phenylimidazole, 1-cyanoethyl-2-phenylimidazole, 2-phenyl-4,5-dihydroxymethylimidazole, 2-phenyl-4-methyl-5-hydroxymethylimidazole, 2,4,5-triphenylimidazole, 1-benzyl-2-imidazole, 1,2-dimethylimidazole, and 1-benzyl-2-phenylimidazole.

Examples of the quaternary ammonium salt include tetramethylammonium chloride, tetraethylammonium chloride, tetrabutylammonium chloride, benzyltrimethylammonium chloride, benzyltriethylammonium chloride, benzyltributylammonium chloride, tetramethylammonium bromide, tetraethylammonium bromide, tetrabutylammonium bromide, benzyltrimethylammonium bromide, benzyltriethylammonium bromide, tetramethylammonium iodide, tetraethylammonium iodide, tetrabutylammonium iodide, and benzyltributylammonium iodide.

Examples of the organometallic salt include organometallic salts such as bis(2,4-pentanedionato)zinc(II), zinc octylate, zinc naphthenate, cobalt naphthenate, copper naphthenate, iron acetylacetone, nickel octylate, and manganese octylate.

Examples of the phosphorus compound include tetraphenyl phosphonium tetra-p-tolyl borate, tetraphenyl phosphonium tetraphenyl borate, triphenylphosphine, tri-p-tolyl phosphine, tris(4-chlorophenyl)phosphine, tris(4-methoxyphenyl)phosphine, tris(2,6-dimethoxyphenyl)phosphine, triphenylphosphine triphenylborane, tetraphenyl phosphonium dicyanamide, and tetraphenyl phosphonium tetra(4-methylphenyl)borate.

The content of the component (C) may be 0.01% by mass or more, 0.1% by mass or more, or 0.5% by mass or more, and may be 10% by mass or less, 5% by mass or less, or 2% by mass or less, based on the total amount of the thermosetting composition.

### Component (D): photoradical generator

The component (D) is a component generating radicals by light irradiation in the cured product of the thermosetting composition. Examples of the component (D) include a hydrogen abstraction type photoradical polymerization initiator generating a radical by extracting hydrogen from another molecule by light irradiation, and an intramolecular cleavage type photoradical polymerization initiator generating two radicals by photocleaving itself by light irradiation. The component (D) may be an intramolecular cleavage type photoradical polymerization initiator because (photo-melting) reaction easily proceeds.

Examples of a hydrogen abstraction type photoradical generator include a hexaarylbisimidazole (HABI) compound, a benzophenone compound, a thioxanthone compound, a fluorenone compound, and an α-diketone compound.

Examples of the HABI compound include 2,2'-bis(o-chlorophenyl)-4,4',5,5'-tetraphenyl biimidazole (for example, 2,2'-bis(2-chlorophenyl)-4,4',5,5'-tetraphenyl-1,2'-biimidazole), 2,2'-bis(o-bromophenyl)-4,4',5,5'-tetraphenyl biimidazole, 2,2'-bis(o,p-dichlorophenyl)-4,4',5,5'-tetraphenyl biimidazole, 2,2'-bis(o-chlorophenyl)-4,4',5,5'-tetra(m-methoxyphenyl)biimidazole, 2,2'-bis(o,o'-dichlorophenyl)-4,4',5,5'-tetraphenyl biimidazole, 2,2'-bis(o-nitrophenyl)-4,4',5,5'-tetraphenyl biimidazole, and 2,2'-bis(o-methylphenyl)-4,4',5,5'-tetraphenyl biimidazole.

Examples of the benzophenone compound include 4,4'-bis(dimethylamino)benzophenone, 4,4'-bis(diethylamino)benzophenone.

Examples of the thioxanthone compound include thioxanthone, 2-isopropylthioxanthone, 2-dodecylthioxanthone, 2-cyclohexylthioxanthone, 2,4-diethylthioxanthone, 2,4-dimethylthioxanthone, 1-phenoxythioxanthone, 1-methoxycarbonylthioxanthone, 2-ethoxycarbonylthioxanthone, 3-(2-methoxyethoxycarbonyl)-thioxanthone, 4-butoxycarbonylthioxanthone, 3-butoxycarbonyl-7-methylthioxanthone, 3,4-di-[2-(2-methoxyethoxy)-ethoxycarbonyl]-thioxanthone, 2-chlorothioxanthone, 1-ethoxycarbonyl-3-ethoxythioxanthone, 1-ethoxycarbonyl-3-chlorothioxanthone, 1-chloro-4-n-propoxythioxanthone, 2-methyl-6-dimethoxymethyl-thioxanthone, 2-methyl-6-(1,1-dimethoxybenzyl)-thioxanthone, 6-ethoxycarbonyl-2-methoxy-thioxanthone, 6-ethoxycarbonyl-2-methylthioxanthone, 1-ethoxycarbonyl-3-(1-methyl-1-morpholinoethyl)-thioxanthone, 2-morpholinomethylthioxanthone, 2-methyl-6-morpholinomethylthioxanthone, and thioxanthone-2-carboxylic acid polyethylene glycol ester.

Examples of the fluorenone compound include 9-fluorenone, 3,4-benzo-9-fluorenone, 2-dimethylamino-9-fluorenone, 2-methoxy-9-fluorenone, 2-chloro-9-fluorenone, 2,7-dichloro-9-fluorenone, 2-bromo-9-fluorenone, 2,7-dibromo-9-fluorenone, 2-nitro-9-fluorenone, and 2-acetoxy-9-fluorenone.

Examples of the α-diketone compound include benzil (a compound also referred to as diphenylethanedione or dibenzoyl).

Examples of an intramolecular cleavage type photoradical generator include a benzyl ketal-based photoradical generator, an α-aminoalkyl phenone-based photoradical generator, an α-hydroxyalkyl phenone-based photoradical generator, an α-hydroxy acetophenone-based photoradical generator, and an acylphosphine oxide-based photoradical generator.

Examples of the benzyl ketal-based photoradical generator include 2,2-dimethoxy-1,2-diphenylethan-1-one (Omnirad 651).

Examples of the α-aminoalkyl phenone-based photoradical generator include 2-benzyl-2-dimethylamino-1-(4-morpholinophenyl)-butanone-1 (Omnirad 369), 2-methyl-1-[4-(methylthio)phenyl]-2-morpholinopropan-1-one (Omnirad 907), and 2-dimethylamino-2-(4-methyl-benzyl)-1-(4-morpholine-4-yl-phenyl)-butan-1-one (Omnirad 379EG).

Examples of the α-hydroxyalkyl phenone-based photoradical generator include 1-hydroxy-cyclohexyl-phenyl-ketone (Omnirad 184).

Examples of the α-hydroxy acetophenone-based photoradical generator include 2-hydroxy-1-{4-[4-(2-hydroxy-2-methyl-propionyl)-benzyl]-phenyl}-2-methyl-propan-1-one (Omnirad 127) and 2-hydroxy-2-methyl-1-phenyl-propan-1-one (Omnirad 1173).

Examples of the acylphosphine oxide-based photoradical generator include 2,4,6-trimethylbenzoyl-diphenyl-phosphine oxide (Omnirad TPO H) and bis(2,4,6-trimethylbenzoyl)-phenylphosphine oxide (Omnirad 819).

The content of the component (D) may be 1% by mass or more, 5% by mass or more, or 10% by mass or more, and may be 30% by mass or less, 20% by mass or less, or 15% by mass or less, based on the total amount of the thermosetting composition.

The thermosetting composition may further contain other components other than the component (A), the component (B), the component (C), and the component (D). Examples of the other components include additives such as a plasticizer, an adhesion-imparting agent such as a tackifier, an antioxidant, a leuco dye, a sensitizer, an adhesion improver such as a coupling agent, a polymerization inhibitor, a light stabilizer, a defoaming agent, a filler, a chain transfer agent, a thixotropy-imparting agent, a flame retardant, a mold-releasing agent, a surfactant, a lubricant, and an antistatic agent. As these additives, known additives can be used. The content of the other components may be 0 to 95% by mass, 0.01 to 50% by mass, or 0.1 to 10% by mass, based on the total amount of the thermosetting composition.

The thermosetting composition may be used as a varnish of the thermosetting composition diluted with a solvent. Examples of the solvent include aromatic hydrocarbons such as toluene, xylene, mesitylene, cumene, and p-cymene; aliphatic hydrocarbons such as hexane and heptane; cyclic alkanes such as methylcyclohexane; cyclic ethers such as tetrahydrofuran and 1,4-dioxane; ketones such as acetone, methyl ethyl ketone, methyl isobutyl ketone, cyclohexanone, and 4-hydroxy-4-methyl-2-pentanone; esters such as methyl acetate, ethyl acetate, butyl acetate, methyl lactate, ethyl lactate, and γ-butyrolactone; carbonic esters such as ethylene carbonate and propylene carbonate; and amides such as N,N-dimethylfonnamide, N,N-dimethylacetamide, and N-methyl-2-pyrrolidone (NMP). The solid content in the varnish, that is, the total content of components other than the solvent in the varnish may be 10 to 95% by mass, 15 to 70% by mass, or 20 to 50% by mass, based on the total amount of the varnish.

The thermosetting composition can be prepared, for example, by a method including mixing or kneading the component (A), the component (B), the component (C), and the component (D), and other components to be added as necessary. The mixing and kneading can be performed by appropriately combining a general stirrer, a mortar machine, and a disperser such as a triple roll mill, a ball mill, and a bead mill.

The thermosetting composition can be heated to form a cured product of the thermosetting composition. By heating the thermosetting composition, a (curing) reaction of the component (A) and the component (B) (for example, a compound having a glycidyl ether group as a cyclic ether group) proceeds. At this time, the component (C) can promote the reaction. A reaction product of the component (A) and the component (B) may be, for example, a compound (polymer) including a structure represented by the following formula. On the other hand, the component (D) has a low involvement in this (curing) reaction, and the cured product may contain the reaction product of the component (A) and the component (B) and the component (D).

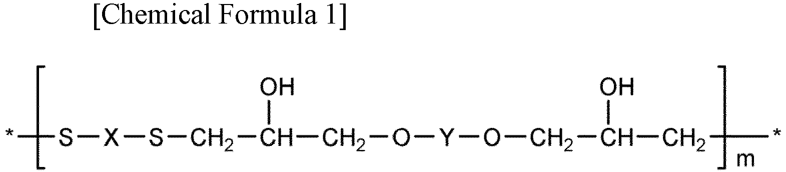

In the formula, "X" represents a first linking group, and "Y" represents a second linking group. "m" represents an integer of 1 or more. "m" may be, for example, 50 or more, 100 or more, 500 or more, or 1000 or more. * represents a bonding site.

The heating temperature of the thermosetting composition may be, for example, 0 to 200°C and may be 30 to 150°C or 60 to 100°C. The heating time of the thermosetting composition may be, for example, 0.1 to 168 hours, and may be 72 hours or less, 24 hours or less, 12 hours or less, 6 hours or less, 4 hours or less, 3 hours or less, or 2 hours or less.

The cured product of the thermosetting composition can be formed into various shapes. For example, a cured product formed in a membrane shape (film shape) can be used as a film. A cured product formed in a block shape can be used as a block. A method of forming a membrane-shaped (film-shaped) or block-shaped cured product is not particularly limited, and a known method can be applied.

The cured product of the thermosetting composition has the property of melting by light irradiation. Light for light irradiation may be, for example, light including light at a wavelength of 365 nm. By irradiation with such light, the cured product can be melted. The exposure amount of light irradiation may be, for example, 1000 mJ/cm² or more. In the present specification, the exposure amount means a product of illumination (mW/cm²) and an irradiation time (sec). The irradiation of light may be performed directly with respect to an object to be irradiated, and may be performed through glass or the like. A light source used for light irradiation is not particularly limited, and examples thereof include an LED lamp, a mercury lamp (such as a low-pressure, high-pressure, or super high-pressure mercury lamp), a metal halide lamp, an excimer lamp, and a xenon lamp. Among these, the light source used for light irradiation may be an LED lamp, a mercury lamp, or a metal halide lamp.

By irradiating the cured product of the thermosetting composition with light, the component (D) in the cured product cleaves the disulfide bond (-S-S-) in the reaction product of the component (A) and the component (B). Thereby, the molecular weight of the reaction product of the component (A) and the component (B) is decreased, so that the cured product can become a liquid (liquid form). Since the cured product of the thermosetting composition is melted by light irradiation, the cured product can also be called a photo-meltable composition. This photo-meltable composition may contain the reaction product of the component (A) and the component (B) and the component (D).

The resin component generated by melting the cured product of the thermosetting composition (photo-meltable composition) by light irradiation has many polyether chains or hydroxyl groups and tends to be hydrophilic, so that this resin component can be removed with an aqueous solvent. Examples of the aqueous solvent include water and a mixed solvent of water and a hydrophilic organic solvent. In a mixed solvent of water and a hydrophilic organic solvent, the ratio of water can be set to, for example, 80% by mass or more. For example, a pH adjuster may be added to the aqueous solvent.

Examples of water include tap water, natural water, purified water, distilled water, ion-exchange water, pure water, ultrapure water (such as Milli-Q water). Note that, Milli-Q water refers to ultrapure water obtained by a Milli-Q water production apparatus of Merck Millipore (Merck & Co., Inc.). Since impurities are reduced, water may be purified water, distilled water, ion-exchange water, pure water, or ultrapure water.

Examples of the hydrophilic organic solvent include alcohols such as methanol, ethanol, 2-propanol, and 1,2-propanediol; and glycol ethers such as ethylene glycol monomethyl ether, propylene glycol monomethyl ether, ethyl cellosolve, propylene glycol monopropyl ether, propylene glycol monoisopropyl ether, butyl cellosolve, ethylene glycol monoisobutyl ether, propylene glycol monobutyl ether, diethylene glycol dimethyl ether, diethylene glycol diethyl ether, and dipropylene glycol monomethyl ether.

Examples of the pH adjuster include an inorganic acid, an inorganic base, an organic acid, and an organic base. Examples of the inorganic acid include nitric acid, sulfuric acid, hydrochloric acid, phosphoric acid, and boric acid. Examples of the inorganic base include sodium hydroxide, potassium hydroxide, and calcium hydroxide. Examples of the organic acid include formic acid, acetic acid, propionic acid, butyric acid, acrylic acid, benzoic acid, and picolinic acid. Examples of the organic base include primary amine, secondary amine, tertiary amine, tetramethylammonium hydroxide, tetraethylammonium hydroxide, and an imidazole-based compound.

The thermosetting composition of the present embodiment can be used for use applications such as a temporary fixing adhesive, a medical adhesive, an easy-to-disassemble adhesive, a reflow sheet material, a photoresist material (photoresist which can be developed without alkali), and a 3D printer material.

A method for producing a structural body of one embodiment includes irradiating at least a part of a first structural body composed of the above-described cured product of the thermosetting composition or the above-described photo-meltable composition with light, and developing the first structural body irradiated with light with an aqueous solvent to obtain a second structural body. The method for producing a structural body is a method for producing a second structural body. The second structural body is a structure from which the cured product of the thermosetting composition or the photo-meltable composition of the portion (a part) irradiated with light is removed from the first structural body, and may be a structural body having a desired recess shape.

The first structural body is obtained by forming the above-described cured product of the thermosetting composition or the above-described photo-meltable composition into various shapes. The first structural body may have a shape such as a membrane shape (film shape) or a block shape, and may be a film, a block, or the like. A method of forming the first structural body is not particularly limited, and a known method can be applied.

The type of light, the exposure amount of light irradiation, the irradiation of light, the light source used for light irradiation, and the like when the first structural body is irradiated with light may be the same as described above.

In the cured product of the thermosetting composition or the photo-meltable composition, as in a positive photoresist, the area irradiated with light by development is removed with an aqueous solvent, and the area not irradiated with light remains, so that a desired recess shape can be formed. In the case of irradiating the first structural body with light, for example, by using a photomask or the like, a predetermined area (recess formation area) can be selectively irradiated with light.

By developing the first structural body irradiated with light with an aqueous solvent, a second structural body from which the cured product of the thermosetting composition or the photo-meltable composition of the portion (a part) irradiated with light is removed from the first structural body can be obtained. The aqueous solvent may be the same as described above.

The second structural body may be a film, a block, or the like having a desired recess shape. Specific examples of the second structural body include a pattern of a semiconductor resist and a culture substratum.

### Examples

Hereinafter, the present disclosure will be more specifically described by means of Examples. However, the present disclosure is not limited to these Examples.

The compounds shown below were prepared.
Component (A):
   (A-1) THIOKOL LP-3 (dithiol compound, manufactured by Toray Fine Chemicals Co., Ltd.)
Component (B):
   Component (B1):
      (B1-1) DENACOL EX-841 (oxirane compound, number of oxirane groups: 2, manufactured by Nagase ChemteX Corporation, epoxy equivalent: 372 g/eq)
   Component (B2):
      (B2-1) DENACOL EX-512 (oxirane compound, number of oxirane groups: 4, manufactured by Nagase ChemteX Corporation, epoxy equivalent: 168 g/eq)
Component (C):
   (C-1) DMP-30 (2,4,6-tris(dimethylaminomethyl)phenol)
Component (D):
   (D-1) Omnirad 651 (2,2-dimethoxy-1,2-diphenylethan-1-one (manufactured by IGM Resins B.V.))

### (Examples 1 to 4 and Comparative Example 1)

### [Preparation of thermosetting composition]

The component (A) and the component (D) of the components and amounts (unit: parts by mass) shown in Table 1 were added to a 35 mL ointment jar, mixed using a rotary and revolutionary stirring machine (manufactured by THINKY CORPORATION, trade name: THINKY MIXER ARE-310) at 2000 rpm for 90 seconds, and then heated at 90°C for 15 minutes. After cooling, the component (B) and the component (C) were added thereto, and stirred using a rotary and revolutionary stirring machine at 2000 rpm for 90 seconds to obtain a thermosetting composition of each of Examples 1 to 4 and Comparative Example 1.

### [Curability test]

The prepared thermosetting composition was placed in a thermostat bath (manufactured by ESPEC CORP., trade name: STH-120) set at 90°C, and the surface of the thermosetting composition was gently prodded every 1 hour using a spatula. At that time, 1 hour after the thermosetting composition stopped adhering to the spatula was regarded as the curing time, and the curability of the thermosetting composition was evaluated. Results are shown in Table 1.

### [Production of film]

The prepared thermosetting composition was injected into a mold form in which a silicone spacer having a thickness of 0.5 mm was sandwiched between a release-treated polyethylene terephthalate film (release PET, manufactured by Nakamoto Packs Co., Ltd., trade name: NS-38+A-500, thickness: 70 µm) and a glass plate. The mold form into which the thermosetting composition had been injected was placed in a thermostat bath set at 90°C, and heated for the curing time determined in the above-described curability test (curing time shown in Table 1) to obtain a film composed of the cured product of the thermosetting composition.

### [Photo-meltability test]

The film produced above was irradiated with light using an LED (main wavelength: 365 nm, illumination: 1000 mW/cm²) so as to obtain the exposure amount shown in Table 1. After irradiation, the release PET was peeled off, and the presence or absence of liquefaction of the light-irradiated area was confirmed by visual observation and examination by touch with the spatula. In a case where the entire light-irradiated area was liquid and no solid matter was present was evaluated as "A", and a case where the light-irradiated area was almost liquid but a part of solid matter remained was evaluated as "B". Note that, in Comparative Example 1, the light-irradiated area did not liquefy but remained as solid matter. Results are shown in Table 1.

### [Water solubility after photo-melting]

0.05 g of the liquid portion (resin component) of the area irradiated with light in the photo-meltability test was weighed into a sample bottle, 5 g of pure water was further added, and the mixture was gently shaken. In a case where the resin component was dissolved in pure water and the water was transparent without turbidity was evaluated as "A", and a case where there was slight turbidity was evaluated as "B". Results are shown in Table 1.

**[Table 1]**

| | | | Comp. Exam. 1 | Exam. 1 | Exam. 2 | Exam. 3 | Exam. 4 |
|---|---|---|---|---|---|---|---|
| (A) | | (A-1) | 42 | 36 | 41 | 41 | 41 |
| (B) | (B1) | (B1-1) | 57 | 50 | 38 | 41 | 43 |
| | (B2) | (B2-1) | - | - | 8 | 4 | 2 |
| (C) | | (C-1) | 1 | 1 | 1 | 1 | 1 |
| (D) | | (D-1) | - | 13 | 13 | 13 | 13 |
| Cyclic ether group of (B)/Thiol group of (A) | | | 1.9 | 1.9 | 1.8 | 1.7 | 1.6 |
| Curing time (hr) | | | 16 | 16 | 2 | 3 | 4 |
| Photo-meltability (exposure amount (mJ/cm²)) | | | - | A (3000) | B (10000) | A (5000) | A (4000) |
| Water solubility after photo-melting | | | - | A | B | B | A |

As shown in Table 1, the thermosetting compositions of Examples 1 to 4 exhibited photo-meltability and were excellent in water solubility of the resin component. From the above, it was confirmed that the thermosetting composition of the present disclosure can form a cured product (photo-meltable composition) which can be melted by light irradiation and in which a resin component generated by melting by light irradiation can be removed with an aqueous solvent.

## Claims

1. A thermosetting composition comprising:
a polythiol compound having a disulfide bond;
a cyclic ether compound having a polyether chain and two or more cyclic ether groups;
a curing accelerator; and
a photoradical generator.

2. The thermosetting composition according to claim 1, comprising a compound having two cyclic ether groups and a compound having three or more cyclic ether groups as the cyclic ether compound.

3. The thermosetting composition according to claim 1 or 2, wherein the cyclic ether group is an oxirane group.

4. A cured product of the thermosetting composition according to any one of claims 1 to 3.

5. A method for producing a structural body, the method comprising:
irradiating at least a part of a first structural body composed of the cured product of the thermosetting composition according to claim 4 with light; and
developing the first structural body irradiated with light with an aqueous solvent to obtain a second structural body.

## Patentansprüche

1. Wärmehärtende Zusammensetzung, umfassend:
eine Polythiolverbindung mit einer Disulfidbindung;
eine cyclische Etherverbindung mit einer Polyetherkette und zwei oder mehr cyclischen Ethergruppen;
einen Härtungsbeschleuniger; und
einen Photoradikalgenerator.

2. Wärmehärtende Zusammensetzung nach Anspruch 1, die eine Verbindung mit zwei cyclische Ethergruppen und eine Verbindung mit drei oder mehr cyclische Ethergruppen als cyclische Etherverbindung umfasst.

3. Wärmehärtende Zusammensetzung nach Anspruch 1 oder 2, wobei die cyclische Ethergruppe eine Oxirangruppe ist.

4. Gehärtetes Produkt aus der wärmehärtenden Zusammensetzung nach einem der Ansprüche 1 bis 3.

5. Verfahren zum Herstellen eines Strukturkörpers, das Verfahren umfassend:
das Bestrahlen mindestens eines Teils eines ersten Strukturkörpers, der aus dem gehärteten Produkt aus der wärmehärtenden Zusammensetzung nach Anspruch 4 besteht, mit Licht; und
das Entwickeln des mit Licht bestrahlten ersten Strukturkörpers mit einem wässrigen Lösungsmittel, um einen zweiten Strukturkörper zu erhalten.

## Revendications

1. Composition thermodurcissable comprenant :
un composé polythiol ayant une liaison disulfure ;
un composé éther cyclique ayant une chaîne polyéther et deux ou plusieurs groupes éther cycliques ;
un accélérateur de durcissement ; et
un générateur photoradicalaire.

2. Composition thermodurcissable selon la revendication 1, comprenant un composé ayant deux groupes éther cycliques et un composé ayant trois groupes éther cycliques ou plus en tant que composé éther cyclique.

3. Composition thermodurcissable selon la revendication 1 ou 2, dans laquelle le groupe éther cyclique est un groupe oxirane.

4. Produit durci de la composition thermodurcissable selon l'une quelconque des revendications 1 à 3.

5. Procédé permettant de produire un corps structurel, le procédé comprenant :
l'irradiation d'au moins une partie d'un premier corps structurel composé du produit durci de la composition thermodurcissable selon la revendication 4 avec de la lumière ; et
le développement du premier corps structurel irradié avec de la lumière avec un solvant aqueux pour obtenir un second corps structurel.
